# EUROPÄISCHE PATENTSCHRIFT

(11) **EP 1 961 035 B1**
(45) Veröffentlichungstag und Bekanntmachung des Hinweises auf die Patenterteilung: **20.05.2009**
(21) Anmeldenummer: 06829658.1
(22) Anmeldetag: 15.12.2006
(51) Int. Cl.: H01L 21/00, B05C 1/08

(54) **VORRICHTUNG UND VERFAHREN ZUR OBERFLÄCHENBEHANDLUNG VON SUBSTRATEN**
DEVICE AND METHOD FOR TREATING THE SURFACES OF SUBSTRATES
PROCEDE ET DISPOSITIF DE TRAITEMENT DE SURFACE DE SUBSTRATS

(30) Priorität: 16.12.2005 DE 102005062527
(43) Veröffentlichungstag der Anmeldung: 27.08.2008
(73) Patentinhaber: Gebr. Schmid GmbH + Co., 72250 Freudenstadt (DE)
(72) Erfinder: KAPPLER, Heinz, 72280 Dornstetten-Aach (DE)
(74) Vertreter: Patentanwälte Ruff, Wilhelm, Beier, Dauster & Partner
(86) Internationale Anmeldenummer: PCT/EP2006/012117
(87) Internationale Veröffentlichungsnummer: WO 2007/073887

(56) Entgegenhaltungen:
- DE-A1- 10 225 848
- US-A- 5 232 501
- US-B1- 6 489 394

## Beschreibung

Die Erfindung betrifft eine Vorrichtung zur Oberflächenbehandlung von Substraten, mit zumindest einem Transportmittel zum Transport eines insbesondere aus Siliziumwerkstoff hergestellten Substrats und mit zumindest einem Fördermittel, das für eine Benetzung einer Substratoberfläche mit einem flüssigen, gasförmigen oder sprühnebelartigen Prozessmedium in einer vom Transportmittel bestimmten Transportebene vorgesehen ist. Ebenso betrifft die Erfindung ein Verfahren zur Benetzung einer Substratoberfläche eines insbesondere aus Siliziummaterial hergestellten Substrats mit einem Prozessmedium.

Aus der DE 102 25 848 A1 sind eine Vorrichtung und ein Verfahren bekannt, die für die Entfernung einer Schicht von einer Oberseite eines flächigen Substrats eingesetzt werden. Dabei wird ein Lösemittel mit Düsen schräg von oben auf die Substrate gespritzt. Die Substrate liegen auf Transportwellen und werden von diesen transportiert. Die Substrate stehen zumindest mit einem seitlichen Ende über die Transportwellen hinaus, so dass vom Substrat abfließendes Lösemittel, das abgelöste Schichtbestandteile enthält, durch den Überstand der Substrate an den Transportmitteln vorbeiströmt. Dadurch soll eine Verunreinigung der Transportmittel verhindert werden. Der Schichtabtrag mit dem Lösemittel dient zur Entfernung von photoaktiven Schichten vor einem Ätzvorgang, um sicherzustellen, dass nur belichtete und entwickelte Oberflächenbereiche des Substrat mit einer für den Ätzvorgang wirksamen Schutzschicht versehen sind. Eine Strukturierung der Schichten ist also bereits durch die Belichtung und Entwicklung der photoaktiven Schichten vorgenommen worden.

Bei anderen Prozessen zur Oberflächenbehandlung, insbesondere zum Schichtabtrag, die an Substraten, beispielsweise an Siliziumscheiben oder -platten, die als Wafer bezeichnet und insbesondere für die Produktion von Halbleiterbauelementen und Solarzellen eingesetzt werden, vorgenommen werden, kann eine Benetzung von einzelnen Oberflächen des Substrats mit Prozessmedium vorgesehen sein. Die Benetzung soll so erfolgen, dass die übrigen Substratoberflächen, die keine Schutzschicht in der oben genannten Art oder eine andere Beschichtung aufweisen, nicht von dem aufzubringenden Prozessmedium angegriffen werden, so dass eine Schichtabtrag nur an der mit Prozessmedium benetzten Substratoberfläche stattfindet. Dies ist mit der bekannten Vorrichtung nicht gewährleistet.

### Aufgabe und Lösung

Der Erfindung liegt die Aufgabe zugrunde, eine Vorrichtung sowie ein Verfahren zu schaffen, die eine selektive Oberflächenbehandlung von Substraten ermöglichen.

Diese Aufgabe wird gemäß einem ersten Aspekt der Erfindung durch eine Vorrichtung mit den Merkmalen des Anspruchs 1 gelöst, bei der das Fördermittel für eine Aufbringung des Prozessmediums auf eine in der Transportebene angeordnete, nach unten gewandte Substratoberfläche gestaltet ist und zumindest ein Absaugmittel zur Absaugung von gasförmig und/oder nebelartig verteiltem Prozessmedium aus der Umgebung des Fördermittels vorgesehen ist, wobei das zumindest eine Absaugmittel in vertikaler Richtung unterhalb der Transportebene angeordnet ist. Vorteilhafte sowie bevorzugte Ausgestaltungen der Erfindung sind Gegenstand der weiteren Ansprüche und werden im folgenden näher erläutert. Die Vorrichtung und das Verfahren werden teilweise gemeinsam erläutert, wobei diese Erläuterungen sowie die entsprechenden Merkmale dennoch unabhängig für Vorrichtung und Verfahren gelten. Der Wortlaut der Ansprüche wird durch die ausdrückliche Bezugnahme zum Inhalt der Beschreibung gemacht.

Die nach unten gewandte Substratoberfläche ist im Wesentlichen eben und ist derart ausgerichtet, dass eine Flächennormale auf diese Substratoberfläche zumindest im Wesentlichen lotrecht in vertikaler Richtung verläuft. Die nach unten gewandte Substratoberfläche ist in der Transportebene angeordnet und stellt die mit Prozessmedium zu benetzende Oberfläche dar. Weitere nach unten gewandte Substratoberflächen, die nicht in der Transportebene liegen, sollen hingegen nicht mit Prozessmedium benetzt werden.

Die Transportebene stellt diejenige Ebene dar, in der ein zu transportierendes Substrat die Transportmittel berührt und ist im Wesentlichen horizontal ausgerichtet oder nimmt einen spitzen Winkel mit einer Horizontalen ein. Je nach Anordnung der Transportmittel kann die Transportebene als gekrümmte Transportfläche ausgeführt sein, wobei eine zumindest im Wesentlichen horizontale Ausrichtung von Transportflächenabschnitten vorgesehen ist.

Eine Fördereinrichtung, die für eine Benetzung einer nach unten gewandten Substratoberfläche mit Prozessmedium in der Transportebene vorgesehen ist, kann beispielsweise als Flüssigkeitswelle in der Art einer Lötwelle ausgeführt sein. Das heißt, dass das flüssige Prozessmedium über eine längliche, bogenförmig profilierte Kante gepumpt wird, so dass eine nach oben ragende Flüssigkeitswelle erzeugt wird, die in einem Scheitelpunkt die Transportebene berührt.

Denkbar ist auch eine Ausführung der Fördereinrichtung als Sprüheinrichtung, die im Wesentlichen in vertikaler Richtung nach oben gerichtete Sprühstrahlen abgeben kann. Abhängig von der Kontur des Substrats kann auch mit einer Sprüheinrichtung eine selektive Benetzung der nach unten gewandten Substratoberflächen erzielt werden.

Bei einer bevorzugten Ausführungsform der Erfindung ist vorgesehen, das Prozessmedium in direktem mechanischen Kontakt zwischen einer beispielsweise als Walze oder als Förderband ausgeführten Fördereinrichtung und der nach unten gewandten Substratoberfläche aufzubringen. Die Fördereinrichtung weist zu diesem Zwecke eine zur Benetzung der Substratoberfläche geeignete Oberflächenstruktur auf und wird gegebenenfalls von einer Dosiereinrichtung mit Prozessmedium versorgt. Die Fördereinrichtung wird kann angetrieben oder bewegbar ausgeführt sein. Damit kann eine Abwälzung einer Außenoberfläche der Fördereinrichtung auf der Substratoberfläche zur Übertragung des Prozessmediums, bevorzugt bei gleichen Oberflächengeschwindigkeiten des in Transportrichtung bewegten Substrats und der die Transportebene berührenden Außenoberfläche der Fördereinrichtung, erfolgen.

Unabhängig von der Art der Benetzung der nach unten gewandten Oberfläche des Substrats kann im Bereich der Fördereinrichtung verdampftes und/oder vernebeltes Prozessmedium auftreten, das sich in unerwünschter Weise auf anderen, nicht nach unten gewandten Oberflächen des Substrats niederschlagen kann. Um eine Beschädigung dieser gegebenenfalls ungeschützten Oberflächen durch das Prozessmedium zu verhindern, sind Absaugmittel vorgesehen, die das dampfförmig und/oder vernebelt vorliegende Prozessmedium aus der Umgebung der Fördereinrichtung absaugen und somit einen Niederschlag auf andere Substratoberflächen verhindern. Das zumindest eine Absaugmittel ist unterhalb der Transportebene angeordnet, um einen im Wesentlichen vertikal nach unten gerichteten Luftstrom hervorrufen zu können und damit ein Aufsteigen von verdampftem und/oder vernebeltem Prozessmedium über die Transportebene nach oben zu verhindern. Typische Prozessmedien wie wässrige Lösungen von Flusssäure, Salzsäure, Salpetersäure oder Kalilauge bilden Gase oder Nebel, die schwerer als Luft sind und die in erster Linie durch die stattfindenden Relativbewegungen zwischen den Transportmitteln und den Substraten über die Transportebene aufsteigen können.

Die Transportebene ist im Wesentlichen horizontal ausgerichtet oder nimmt einen spitzen Winkel mit einer Horizontalen ein. Je nach Anordnung der Transportmittel kann die Transportebene eine gekrümmte Transportfläche sein, wobei eine im Wesentlichen horizontale Ausrichtung von Transportflächenabschnitten bevorzugt ist. Das Absaugmittel basiert auf der Verwendung eines Unterdrucks, der bevorzugt derart gegenüber einem Normaldruck in der Umgebung der Fördereinrichtung gewählt ist, dass eine zumindest nahezu wirbelfreie, insbesondere laminare Luftströmung in vertikaler Richtung nach unten aufgebaut werden kann.

In Ausgestaltung der Erfindung ist vorgesehen, dass das zumindest eine Absaugmittel in einem Zwischenraum angeordnet ist, der von zumindest zwei benachbart angeordneten Transportmitteln und von der Transportebene begrenzt ist. Damit kann eine kompakte Gestaltung der Vorrichtung zur Oberflächenbehandlung von Substraten verwirklicht werden. Die Zwischenräume zwischen den Transportmitteln ermöglichen ein vorteilhaftes Strömen der durch die Absaugmittel angesaugten und im Wesentlichen in vertikaler Richtung herabströmenden Luft. Durch eine Anbringung der Absaugmittel zwischen den Transportmitteln kann auch überschüssiges Prozessmedium, das durch die Relativbewegung, insbesondere durch die Abwälzbewegung, zwischen der bereits mit Prozessmedium benetzten Substratoberfläche und den Transportmitteln in einen gasförmigen und/oder vernebelten Zustand überführt wird, unmittelbar am Ort der Entstehung zuverlässig abgesaugt werden und wird somit aus einem Bereich oberhalb der Transportebene ferngehalten.

In weiterer Ausgestaltung der Erfindung ist vorgesehen, dass das Absaugmittel als langgestreckter Hohlkörper, insbesondere als Rohr, ausgeführt ist und zumindest eine Ansaugöffnung aufweist. Damit kann eine einfache und kostengünstige Ausführung des Absaugmittels verwirklicht werden. Das Absaugmittel kann insbesondere als geschlossener oder geschlitzter Rohrquerschnitt ausgeführt sein, wobei in dem geschlossenen Rohrquerschnitt eine oder mehrere Ansaugöffnungen vorgesehen sind. Bei einem geschlitzten Hohlkörper bildet der sich längs einer Mittellängsachse erstreckende Schlitz die Ansaugöffnung. Als Hohlkörper kommen insbesondere Kunststoff- oder Metallrohre in Frage, die beispielsweise nahtlos hergestellt werden und nachträglich mit den Ansaugöffnungen versehen werden.

In weiterer Ausgestaltung der Erfindung ist vorgesehen, dass das Absaugmittel im Bereich eines mit Prozessmedium gefüllten Beckens angeordnet ist. Damit kann erreicht werden, dass das Absaugmittel auch gasförmiges und/oder vernebeltes Prozessmedium, das oberhalb des als Speicherreservoir für das Prozessmedium dienenden Beckens vorliegen kann, erfassen kann. Damit kann ein Aufsteigen des aus dem Becken austretenden gasförmigen und/oder vernebelten Prozessmediums über die Transportebene verhindert werden, um einen Niederschlag des Prozessmediums auf einer nach oben gewandten Oberfläche des Substrats zu vermeiden.

In weiterer Ausgestaltung der Erfindung ist vorgesehen, dass das Absaugmittel derart in dem Becken angeordnet ist, dass es an einer insbesondere frei von Ansaugöffnungen ausgeführten Unterseite zumindest teilweise vom Prozessmedium benetzbar ist. Damit kann eine besonders kompakte Gestaltung der Vorrichtung zur Oberflächenbehandlung verwirklicht werden. Das im Becken aufgenommene Prozessmedium wird über die Fördereinrichtung zu den zu benetzenden Substratoberflächen gefördert. Damit ein kurzer Förderweg für das Prozessmedium gewährleistet werden kann, der für eine kompakte Gestaltung der Vorrichtung mit verantwortlich ist, wird das Becken für das Prozessmedium derart angeordnet, dass ein Flüssigkeitsspiegel des Prozessmediums nur knapp unterhalb der Transportebene angesiedelt ist. Für das Absaugmittel sollte ein ausreichender Hohlquerschnitt zur Verfügung gestellt werden, der eine Absaugung mit geringen bis mäßigen Strömungsgeschwindigkeiten zur Wahrung einer wirbelarmen Strömung im Bereich oberhalb der Transportebene gewährleistet. Daher wird das bevorzugt als langgestreckter Hohlkörper ausgeführte Absaugmittel derart zwischen dem Becken und der Transportebene angeordnet, dass es zumindest teilweise in das Prozessmedium eintaucht und somit nicht dem gewünschten kurzen Weg für das Prozessmedium entgegensteht.

In weiterer Ausgestaltung der Erfindung ist vorgesehen, dass dem Becken ein zumindest abschnittsweise an einem Beckenrand angeordneter Absaugschacht zur randseitigen Absaugung von gasförmig und/oder nebelartig verteiltem Prozessmedium zugeordnet ist. Damit kann verhindert werden, dass gasförmig oder nebelartig verteiltes Prozessmedium am Rand des Beckens über die Transportebene hinaus aufsteigt und die nach oben gewandte Substratoberfläche beschädigt. Der Absaugschacht kann als zumindest teilweise umlaufender, schlanker Hohlkörper mit zumindest einer Absaugöffnung randseitig am Becken angebracht sein. Bei einer bevorzugten Ausführungsform der Erfindung wird der randseitige Absaugschacht durch eine das Becken zumindest abschnittsweise umgebende Wanne oder Prozesskammer gebildet, die eine schlitzartige, zumindest im Wesentlichen umlaufende Öffnung begrenzt, durch die eine Absaugung in vertikaler Richtung nach unten stattfinden kann.

In weiterer Ausgestaltung der Erfindung ist vorgesehen, dass die zumindest eine Ansaugöffnung des Absaugmittels in einem Bereich oberhalb einer Mittellängsachse des Absaugmittels angeordnet ist. Damit wird ein im Wesentlichen wirbelarmes, insbesondere laminares, Einströmen der vom Absaugmittel angesaugten Umgebungsluft gewährleistet. Durch die oberhalb der Mittellängsachse des Absaugmittels angeordneten Ansaugöffnungen muss die im Wesentlichen in vertikaler Richtung angesaugt Luft im Bereich des Ansaugmittels nicht in unerwünschter Weise umgelenkt werden und ruft somit auch nur geringe oder keine Verwirbelungen hervor, die zu einem unerwünschten Niederschlag von gasförmigem oder vernebelten Prozessmedium auf den nicht zu benetzenden Substratoberflächen führen könnten.

In weiterer Ausgestaltung der Erfindung ist vorgesehen, dass das Absaugmittel mit einer Absaugleitung verbunden ist, wobei zwischen Absaugmittel und Absaugleitung zumindest ein Einstellventil vorgesehen ist. Durch eine Verbindung von Absaugmitteln mit einer Absaugleitung kann eine zentrale Absaugung und eine gegebenenfalls notwendige zentrale Aufbereitung des abgesaugten Gemisches aus Umgebungsluft und gasförmigem und/oder vernebeltem Prozessmedium verwirklicht werden. Die Absaugleitung kann beispielsweise mit einer zentralen Pumpeinrichtung zu Erzeugung eines Unterdrucks versehen sein, so dass eine zentrale Ansteuerung, dass heißt eine Aktivierung und Deaktivierung und eine Einstellung eines Saugvolumenstroms für alle Absaugmittel verwirklicht werden kann. Um eine individuelle Anpassung eines von einzelnen Absaugmitteln durch die Ansaugöffnungen angesaugten Saugvolumenstroms zu ermöglichen, ist zumindest zwischen einem Absaugmittel und der Absaugleitung ein Einstellventil vorgesehen, das insbesondere als einstellbares Drosselventil ausgeführt sein kann und das eine manuelle oder automatisierte Einstellung des Saugvolumenstroms für dieses Absaugmittel erlaubt.

In weiterer Ausgestaltung der Erfindung ist vorgesehen, dass das Absaugmittel zwischen zwei als Transportrollen ausgeführten Transportmitteln angeordnet ist, wobei eine Mittellängsachse des Absaugmittels parallel zu Rotationsachsen der Transportmittel angeordnet ist. Dies erlaubt eine besonders kompakte Gestaltung der Vorrichtung, da sich durch die parallele Anordnung des Absaugmittels zu den als Transportrollen ausgeführten Transportmitteln eine platzsparende Anordnung verwirklichen lässt. Dabei kann das Absaugmittel insbesondere in einem im Wesentlichen von den zylindrischen Transportrollen und der Transportebene begrenzten, im Wesentlichen dreieckigen oder trapezförmigen Zwischenraum aufgenommen werden. Dieser Zwischenraum ergibt sich durch die zylindrische Kontur der Transportrollen und durch die für eine gleichsinnige Bewegung der Transportrollen notwendige Beabstandung zwischen den Transportrollen.

Diese Aufgabe wird gemäß einem zweiten Aspekt der Erfindung durch ein Verfahren mit den Merkmalen des Anspruchs 10 zur Benetzung einer Substratoberfläche eines insbesondere aus Siliziummaterial hergestellten Substrats mit einem Prozessmedium gelöst, das die Schritte aufweist:
- Transport des Substrats mit Transportmitteln in einer Transportebene,
- Benetzung einer zumindest im Wesentlichen in der Transportebene angeordneten, nach unten weisenden Substratoberfläche mit einem Prozessmedium, das mit einer Fördereinrichtung an der Substratoberfläche aufgebracht wird,
- Absaugung von verdampftem und/oder vernebeltem Prozessmedium mit in vertikaler Richtung unterhalb der Transportebene angeordneten Absaugmitteln, um einen Niederschlag des Prozessmediums auf einer anderen als der in der Transportebene angeordneten Substratoberfläche zu verhindern.

Der Transport des Substrats erfolgt bevorzugt in einer im Wesentlichen geradlinigen Transportrichtung in der durch die Transportmittel bestimmten Transportebene. Zu diesem Zweck liegt das Substrat mit der nach unten gewandten Substratoberfläche auf einer Anordnung mehrerer Transportmittel auf, die zumindest teilweise mit einer Antriebseinrichtung gekoppelt sind, von dieser angetrieben werden und somit eine Vorwärtsbewegung des Substrats hervorrufen können. Die Benetzung der nach unten gewandten Substratoberfläche erfolgt bei einer bevorzugten Ausführungsform der Erfindung unmittelbar durch die Transportmittel, die damit auch als Fördereinrichtungen dienen. Ergänzend bzw. alternativ kann die Benetzung auch durch separate Fördereinrichtungen, die zwischen den Transportmitteln unterhalb der Transportebene angeordnet sind, erfolgen. Eine Absaugung von verdampftem und/oder vernebeltem Prozessmedium wird durch Absaugmittel bewirkt, die in vertikaler Richtung unterhalb der Transportebene angeordnet sind und einen Luftstrom in vertikaler Richtung nach unten bewirken, um einen Niederschlag des Prozessmediums auf andere als die in der Transportebene angeordneten Substratoberfläche zu verhindern.

In Ausgestaltung des Verfahrens ist vorgesehen, dass ein kontinuierlicher Transport von Substrat und/oder eine kontinuierliche Bereitstellung von Prozessmedium durch die Fördereinrichtung zur Benetzung der Substratoberfläche und/oder eine kontinuierliche Absaugung von gasförmigem oder vernebeltem Prozessmedium durchgeführt wird. Durch eine kontinuierliche Durchführung des Transports der Substrate und/oder der Bereitstellung von Prozessmedium zur Benetzung der Substratoberfläche und/oder der Absaugung kann ein Bearbeitungsprozess gewährleistet werden, bei dem nur ein minimaler, vorzugsweise ein verschwindender, besonders bevorzugt kein Niederschlag von Prozessmedium auf nicht zu benetzenden Substratoberflächen stattfindet.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen gebieten verwirklicht sein und vorteilhafte sowie für sich schutzfähige Ausführungen darstellen können, für die hier Schutz beansprucht wird, die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ein Ausführungsbeispiel der Erfindung ist in den Zeichnungen schematisch dargestellt und wird im folgenden näher erläutert. Dabei zeigt:
- Fig. 1: eine schematische Darstellung einer Vorrichtung zur Oberflächenbehandlung von Substraten in einer Seitenansicht,
- Fig. 2: eine schematische Darstellung der Vorrichtung gemäß Fig. 1 in einer teilweise geschnittenen Vorderansicht.

### Detaillierte Beschreibung der Ausführungsbeispiele

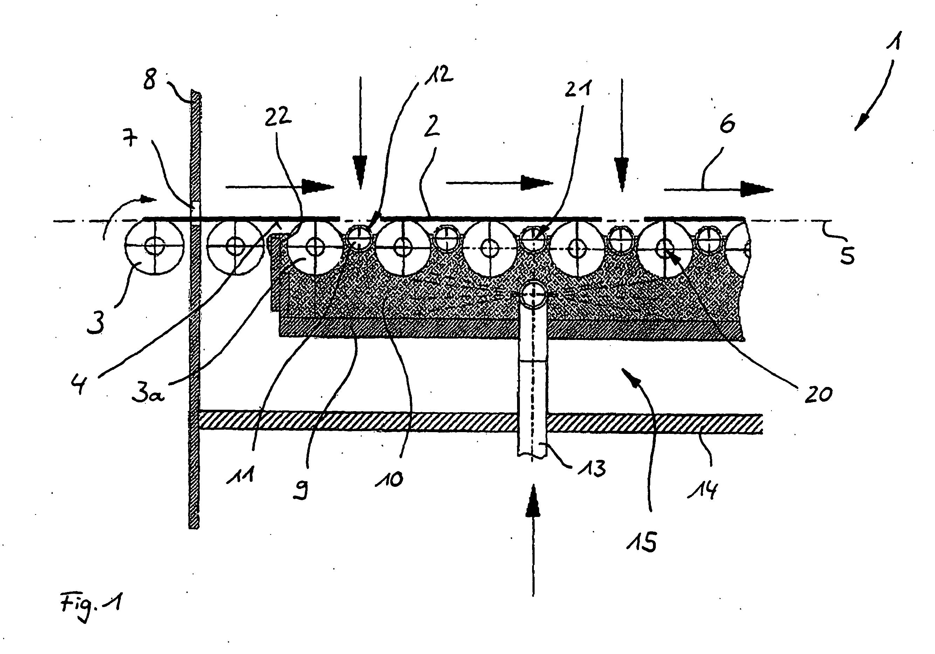

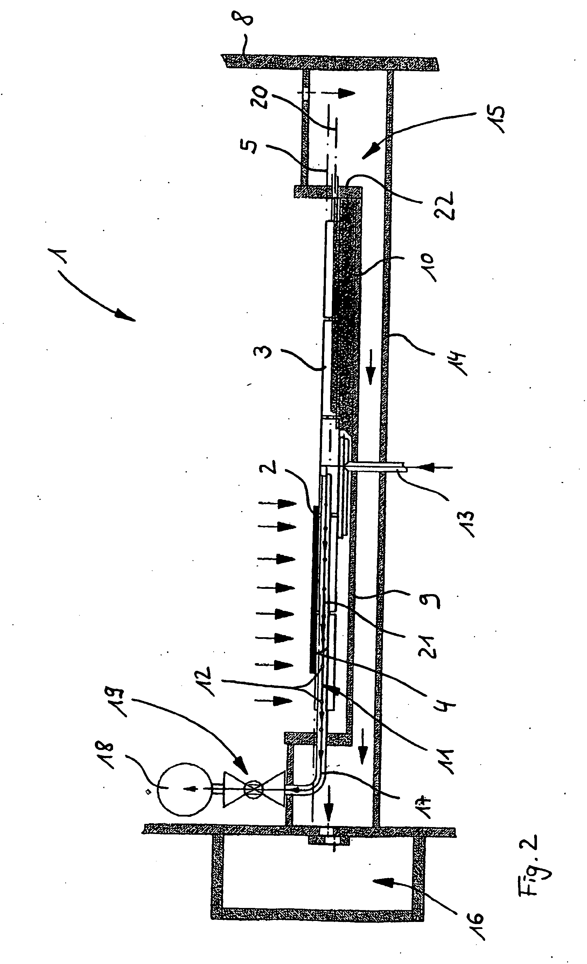

Eine in den Fig. 1 und 2 dargestellte Vorrichtung 1 zur Oberflächenbehandlung von Substraten 2 weist mehrere als Transportrollen 3, 3a ausgeführte Transportmittel auf. Die Transportrollen 3, 3a sind für einen linearen Transport der insbesondere aus Siliziumwerkstoff hergestellten Substrate 2 vorgesehen und abgestimmt. Die Transportrollen 3, 3a begrenzen eine Transportebene 5, die in horizontaler Richtung ausgerichtet ist und die die Transportrollen 3, 3a an einer Oberfläche tangiert. Die Transportrollen 3, 3a sind drehbeweglich in der Vorrichtung 1 gelagert und werden zumindest teilweise von einer nicht dargestellten Antriebseinrichtung mit einer vorzugsweise konstanten, einstellbaren Rotationsgeschwindigkeit angetrieben.

Das Substrat 2 ist typischerweise eine flache, ebene Siliziumplatte, die eine runde Kontur mit einem Durchmesser von ungefähr 60mm bis 250mm oder eine rechteckige Kontur mit Kantenlängen von 60mm bis 250mm aufweist. Eine bevorzugte Dicke des Substrats liegt im Bereich von 0,1mm bis 2mm. Das Substrat 2 liegt mit einer nach unten gewandten Substratoberfläche 4 auf den Transportrollen 3, 3a auf und wird durch die gleichsinnige und gleich schnelle Rotation der Transportrollen 3, 3a in einer Transportrichtung 6 bewegt.

Die Aufgabe der Vorrichtung 1 kann beispielsweise darin bestehen, eine allseitig auf das Substrat 2 aufgetragene Beschichtung an der nach unten gewandten Substratoberfläche 4 in einem nasschemischen Verfahren unter Verwendung eines flüssigen Prozessmediums zu entfernen, ohne die auf die übrigen Oberflächen des Substrats aufgetragene Beschichtung zu beschädigen.

Zu diesem Zweck wird das Substrat 2 mit der Substratoberfläche 4 auf die Transportrollen 3, 3a aufgelegt und durch eine Eingangsöffnung 7 in eine zeichnerisch nur angedeutete, zumindest nahezu vollständig geschlossene Prozesskammer 8 bewegt. In der Prozesskammer 8 ist ein Becken 9 vorgesehen, das vollständig mit einem flüssigen Prozessmedium 10, insbesondere mit wässrigen Lösungen von Flusssäure (HF_{(aq)}) und/oder Salzsäure (HCl_{(aq)}) und/oder Salpetersäure (HNO_{3(aq)}) und/oder Kalilauge (NaOH_{(aq)}) gefüllt sein kann. Das Becken 9 ist mit Abstand zu einem Boden 14 der Prozesskammer 8 angeordnet, so dass zwischen Becken 9 und Boden 14 ein Absaugschacht 15 gebildet ist, der eine Absaugung am Randbereich des Beckens 9 gewährleistet. Wie in der Fig. 2 näher dargestellt, erstreckt sich der Absaugschacht 15 unterhalb des gesamten Beckens 9 und ermöglicht damit eine Absaugung von gasförmigem und/oder vernebeltem Prozessmedium 10, das über den Rand des Beckens 9 hinaustritt und nicht von den Absaugmitteln 11 erfasst wird. Der Absaugschacht 15 ist mit einem seitlich an der Vorrichtung 1 angebrachten Abluftschacht 16 gekoppelt, der mit Unterdruck beaufschlagt ist. Eine Versorgung des Beckens 9 mit frischem Prozessmedium 10 ist über eine Medienleitung 13 vorgesehen.

Um eine Benetzung der nach unten gewandten Substratoberfläche 4 zu gewährleisten, nehmen die Transportrollen 3a eine Doppelfunktion ein, das heißt, sie dienen nicht nur als Transportmittel für das Substrat 2, sondern auch als Fördereinrichtung für das Prozessmedium 10. Für eine Förderung des Prozessmediums 10 aus dem Becken 9 in die Transportebene 5 sind die Transportrollen 3a derart in dem Becken 9 angebracht, dass sie teilweise in das Prozessmedium 10 eingetaucht sind. Die Transportrollen 3a weisen eine benetzbare Oberfläche auf, so dass sie das Prozessmedium 10 in geringer Schichtstärke entgegen der Schwerkraft nach oben in die Transportebene 5 befördern können und in einem Abwälzvorgang, das heißt in einem direkten mechanischen Kontakt auf die Substratoberflächen 4 übertragen können. Da das Prozessmedium 10 nur in geringer Schichtstärke auf den Transportrollen 3a aufliegt, wird selbst bei einer geringen Dicke der Substrate 2 sichergestellt, dass das Prozessmedium 10 nicht auf eine nach oben gewandte Substratoberfläche gelangt.

Um sicherzustellen, dass die nach oben gewandte Substratoberfläche frei von Prozessmedium 10 bleibt, sind Absaugmittel 11 zur Absaugung von gasförmigem und/oder nebelartigem Prozessmedium, das in der Umgebung der als Fördermittel wirkenden Transportrollen 3a vorliegen kann, vorgesehen. Das Prozessmedium 10 weist einen Dampfdruck auf, der sich darin äußert, dass das Prozessmedium 10 in Abhängigkeit von den umgebenden atmosphärischen Bedingungen wie beispielsweise einer Umgebungstemperatur und einem Luftdruck mehr oder weniger stark verdampft und sich mit der Umgebungsluft vermengt. Zudem kann durch die Relativbewegung zwischen den Transportrollen 3a und dem Prozessmedium 10 und durch den Abwälzvorgang des Fördermittels 3a auf der Substratoberfläche 4 auch eine Ablösung von kleinsten Prozessmediumtröpfchen stattfinden, die als fein verteilter Nebel oberhalb des Flüssigkeitsspiegels des Prozessmediums 10 vorliegen. Zwar ist ein Gemisch aus gasförmigem und/oder vernebeltem Prozessmedium 10 mit der Umgebungsluft typischerweise schwerer als die Umgebungsluft. Es findet jedoch durch die Relativbewegungen der Transportmittel 3a und der Substrate 2 eine Verwirbelung der Umgebungsluft statt, die ohne Absaugmittel 11 zu einem Aufsteigen des gasförmigen und/oder vernebelten Prozessmediums über die Transportebene 5 führen kann.

Somit könnte sich gasförmiges und/oder vernebeltes Prozessmedium 10 auf der nach oben gewandten Oberfläche des Substrats 2 niederschlagen. Da dies nicht gewünscht ist, sind die Absaugmittel 11 vorgesehen, die als mit Unterdruck beaufschlagte Rohre zwischen den Transportrollen 3a angebracht sind und die jeweils mehrere Ansaugöffnungen 12 aufweisen, durch die das gasförmige und/oder vernebelte Prozessmedium 10 in einem Bereich unterhalb der Transportebene 5 abgesaugt werden kann und somit nicht über die Transportebene 5 hinaus auf die nach oben gewandte Substratoberfläche gelangen kann. Aus diesem Grund sind die Absaugmittel 11 in vertikaler Richtung unter der Transportebene 5 angeordnet, sie bewirken einen im Wesentlichen in vertikaler Richtung strömenden Luftstrom, der bevorzugt wirbelarm und besondes bevorzug laminar ausgebildet ist.

Die Absaugmittel 11 sind über ein Ableitungsrohr 17 mit einer Absaugleitung 18 verbunden, die über eine nicht dargestellte Pumpeinrichtung mit einem Unterdruck beaufschlagt ist. Zur individuellen Einstellung eines Absaugmittels 11 ist zwischen Ableitungsrohr 17 und Absaugleitung 18 ein Einstellventil 19 vorgesehen, das als Drosselventil ausgebildet ist und das eine Beeinflussung eines von der Absaugleitung 18 angesaugten Volumenstroms ermöglicht.

Für eine besonders kompakte Anordnung der Absaugmittel 11 in der Vorrichtung 1 ist vorgesehen, eine Mittellängsachse 21 der röhrenförmig ausgeführten Absaugmittel 11 parallel zu einer Rotationsachse 20 der Transportrollen 3a auszurichten und die Absaugmittel 11 in einem von den Transportrollen 3a und der Transportoberfläche 5 sowie nach unten vom Flüssigkeitsspiegel des Prozessmediums 10 begrenzten Zwischenraum anzuordnen. Damit kann trotz einer geringen Beabstandung der Transportrollen 3 ein großer Querschnitt für die Absaugmittel 11 verwirklicht werden. So kann selbst bei großen Volumenströmen, die durch die Absaugmittel 11 abgesaugt werden, eine geringe Strömungsgeschwindigkeit in den Absaugmitteln 11 gewährleistet werden. Zudem liegt auch eine große Außenoberfläche der Absaugmittel 11 vor, in die eine große Anzahl von Ansaugöffnungen 12 eingebracht werden können, um im Ergebnis eine wirbelarme, insbesondere laminare Luftströmung in vertikaler Richtung nach unten verwirklichen zu können, die eine zuverlässige Absaugung von gasförmig oder nebelartig verteiltem Prozessmedium 10 gewährleistet.

## Patentansprüche

1. Vorrichtung (1) zur Oberflächenbehandlung von Substraten (2), mit zumindest einem Transportmittel (3, 3a) zum Transport eines insbesondere aus Siliziumwerkstoff hergestellten Substrats (2) und mit zumindest einem Fördermittel (3a), das für eine Benetzung einer Substratoberfläche (4) mit einem flüssigen Prozessmedium (10) in einer vom Transportmittel (3, 3a) bestimmten Transportebene (5) vorgesehen ist, **dadurch gekennzeichnet, dass** das Fördermittel (3a) für eine Aufbringung des Prozessmediums (10) auf eine in der Transportebene (5) angeordnete, nach unten gewandte Substratoberfläche (4) ausgebildet ist und zumindest ein Absaugmittel (11) zur Absaugung von gasförmig und/oder nebelartig verteiltem Prozessmedium (10) aus der Umgebung des Fördermittels (3a) vorgesehen ist, wobei das zumindest eine Absaugmittel (11) in vertikaler Richtung unterhalb der Transportebene (5) angeordnet ist.

2. Vorrichtung nach Anspruch 1, **dadurch gekennzeichnet, dass** das zumindest eine Absaugmittel (11) in einem Zwischenraum angeordnet ist, der von zumindest zwei benachbart angeordneten Transportmitteln (3, 3a) und von der Transportebene (5) begrenzt ist.

3. Vorrichtung nach Anspruch 1 oder 2, **dadurch gekennzeichnet, dass** das Absaugmittel (11) als langgestreckter Hohlkörper, insbesondere als Rohr, ausgeführt ist und zumindest eine Ansaugöffnung (12) aufweist.

4. Vorrichtung nach einem der vorhergehenden Ansprüche, **dadurch gekennzeichnet, dass** das Absaugmittel (11) im Bereich eines mit Prozessmedium (10) gefüllten Beckens (9) angeordnet ist.

5. Vorrichtung nach Anspruch 4, **dadurch gekennzeichnet, dass** das Absaugmittel (11) derart in dem Becken (9) angeordnet ist, dass es an einer insbesondere frei von Ansaugöffnungen (12) ausgeführten Unterseite zumindest teilweise vom Prozessmedium (10) benetzbar ist.

6. Vorrichtung nach Anspruch 4 oder 5, **dadurch gekennzeichnet, dass** dem Becken (9) ein zumindest abschnittsweise an einem Beckenrand (22) angeordneter Absaugschacht (15) zur randseitigen Absaugung von gasförmig und/oder nebelartig verteiltem Prozessmedium (10) zugeordnet ist.

7. Vorrichtung nach Anspruch 5 oder 6, **dadurch gekennzeichnet, dass** die zumindest eine Ansaugöffnung (12) des Absaugmittels (11) in einem Bereich oberhalb einer Mittellängsachse (21) des Absaugmittels (11) angeordnet ist.

8. Vorrichtung nach einem der vorhergehenden Ansprüche, **dadurch gekennzeichnet, dass** das Absaugmittel (11) mit einer Absaugleitung (18) verbunden ist, wobei zwischen Absaugmittel (11) und Absaugleitung (18) zumindest ein Einstellventil (19) vorgesehen ist.

9. Vorrichtung nach Anspruch 2, **dadurch gekennzeichnet, dass** das Absaugmittel (11) zwischen zwei als Transportrollen ausgeführten Transportmitteln (3, 3a) angeordnet ist, wobei eine Mittellängsachse (21) des Absaugmittels (11) parallel zu Rotationsachsen (20) der Transportmittel (3, 3a) angeordnet ist.

10. Verfahren zur Benetzung einer Substratoberfläche (4) eines insbesondere aus Siliziummaterial hergestellten Substrats (2) mit einem Prozessmedium (10) mit den Schritten:
- Transport des Substrats (2) mit Transportmitteln (3, 3a) in einer Transportebene (5),
- Benetzung einer zumindest im Wesentlichen in der Transportebene (5) angeordneten, nach unten weisenden Substratoberfläche (4) mit einem Prozessmedium (10), das mit einer Fördereinrichtung (3a) an der Substratoberfläche (4) aufgebracht wird,
- Absaugung von verdampftem und/oder vernebeltem Prozessmedium (10) mit in vertikaler Richtung unterhalb der Transportebene (5) angeordneten Absaugmitteln (11), um einen Niederschlag des Prozessmediums (10) auf einer anderen als der in der Transportebene (5) angeordneten Substratoberfläche (4) zu verhindern.

11. Verfahren nach Anspruch 10, **gekennzeichnet durch** einen kontinuierlichen Transport von Substrat (2) und/oder eine kontinuierliche Bereitstellung von Prozessmedium (10) **durch** die Fördereinrichtung zur Benetzung der Substratoberfläche (4) und/oder eine kontinuierliche Absaugung von gasförmigem oder vernebeltem Prozessmedium (10).

## Claims

1. A device (1) for the surface treatment of substrates (2), having at least one transport means (3, 3a) for transporting an in particular silicon material substrate (2) and having at least one conveying means (3a), which is provided for wetting a substrate surface (4) with a liquid process medium (10) in a transport plane (5) defined by transport means (3, 3a), **characterized in that** the conveying means (3a) is constructed for applying the process medium (10) to a downwardly directed substrate surface (4) located in transport plane (5), and at least one suction means (11) is provided for the suction of process medium (10) distributed in gas and/or mist form from the environment of conveying means (3a), the at least one suction means (11) being positioned vertically below transport plane (5).

2. The device according to claim 1, **characterized in that** the at least one suction means (11) is placed in a gap defined by at least two adjacently arranged transport means (3, 3a) and the transport plane (5).

3. The device according to claim 1 or 2, **characterized in that** the suction means (11) is constructed as an elongated hollow body, particularly as a pipe, and has at least one suction opening (12).

4. The device according to one of the preceding claims, **characterized in that** the suction means (11) is located in the vicinity of a tank (9) filled with process medium (10).

5. The device according to claim 4, **characterized in that** the suction means (11) is positioned in tank (9) in such a way that it can be at least partly wetted by process medium (10) on an underside which is in particular free from suction openings (12).

6. The device according to claim 4 or 5, **characterized in that** with the tank (9) is associated a suction shaft (15) at least in sections located on a tank edge (22) for the marginal suction of process medium (10) distributed in gas and/or mist form.

7. The device according to claim 4 or 5, **characterized in that** at least one suction opening (12) of suction means (11) is located in an area above the median longitudinal axis (21) of suction means (11).

8. The device according to one of the preceding claims, **characterized in that** the suction means (11) is connected to a suction line (18), there being at least one setting valve (19) between suction means (11) and suction line (18).

9. The device according to claim 2, **characterized in that** the suction means (11) is positioned between two transport means (3, 3a) constructed as transport rollers, a median longitudinal axis (21) of suction means (11) being parallel to the rotation axes (20) of transport means (3, 3a).

10. A method for wetting a substrate surface (4) of an in particular silicon material substrate (2) with a process medium (10) involving the following steps:
- transporting substrate (2) with transport means (3, 3a) in a transport plane (5),
- wetting a downwardly directed substrate surface (4) positioned at least substantially in transport plane (5) with a process medium (10), applied by a conveyor (3a) to substrate surface (4),
- sucking off of process medium (10) in mist and/or vapour form with suction means (11) arranged vertically below the transport plane (5) in order to prevent a deposition of process medium (10) on substrate surfaces other than the substrate surface (4) located in transport plane (5).

11. The method according to claim 10, **characterized by** a continuous transportation substrate (2) and/or a continuous provision of process medium (10) by the conveyor for wetting the substrate surface (4) and/or a continuous suction of process medium (10) in gas or mist form.

## Revendications

1. Dispositif (1) pour le traitement de la surface de substrats (2), avec au moins un moyen de transport (3, 3a) pour le transport d'un substrat (2) fabriqué notamment à partir d'une matière première en silicium, et avec au moins un moyen d'acheminement (3a) qui est prévu pour le mouillage d'une surface de substrat (4) avec une substance de traitement (10) liquide dans un plan de transport (5) déterminé par le moyen de transport (3, 3a), **caractérisé en ce que** le moyen d'acheminement (3a) est réalisé pour l'application d'une substance de traitement (10) sur une surface de substrat (4) disposée dans le plan de transport (5) et orientée vers le bas et qu'on prévoit au moins un moyen d'aspiration (11) pour l'aspiration de la substance de traitement (10) distribuée sous forme gazeuse et/ou nébuleuse hors du milieu ambiant du moyen d'acheminement (3a), sachant que le ou les moyens d'aspiration (11) sont disposés en direction verticale au-dessous du plan de transport (5).

2. Dispositif d'après la revendication 1, **caractérisé en ce que** le ou les moyens d'aspiration (11) sont disposés dans un espace intermédiaire délimité au moins par deux moyens de transport (3, 3a) limitrophes et par le plan de transport (5).

3. Dispositif d'après la revendication 1 ou 2, **caractérisé en ce que** le moyen d'aspiration (11) est réalisé sous forme de corps creux oblong, notamment sous forme de tube, et qu'il présente au moins une ouverture d'aspiration (12).

4. Dispositif d'après une des revendications précédentes, **caractérisé en ce que** le moyen d'aspiration (11) est disposé auprès d'un réservoir (9) rempli de substance de traitement (10).

5. Dispositif d'après la revendication 4, **caractérisé en ce que** le moyen d'aspiration (11) est disposé dans le réservoir (9) de manière à pouvoir être mouillé au moins en partie par la substance de traitement (10) de son côté inférieur qui est réalisé notamment de façon à ne présenter aucune ouverture d'aspiration (12).

6. Dispositif d'après la revendication 4 ou 5, **caractérisé en ce qu'**on attribue au réservoir (9) une fosse d'aspiration (15) disposée au moins sectoriellement auprès d'un bord de réservoir (22) pour l'aspiration latérale de la substance de traitement (10) distribuée sous forme gazeuse et/ou nébuleuse.

7. Dispositif d'après la revendication 4 ou 5, **caractérisé en ce que** la ou les ouvertures d'aspiration (12) du moyen d'aspiration (11) sont disposées dans une zone au-dessus d'un axe médian longitudinal (21) du moyen d'aspiration (11).

8. Dispositif d'après une des revendications précédentes, **caractérisé en ce que** le moyen d'aspiration (11) est raccordé à un conduit d'aspiration (18), sachant qu'on prévoit au moins une soupape de réglage (19) entre le moyen d'aspiration (11) et le conduit d'aspiration (18).

9. Dispositif d'après la revendication 2, **caractérisé en ce que** le moyen d'aspiration (11) est disposé entre deux moyens de transport (3, 3a) réalisés sous forme de roulettes de transport, sachant qu'un axe médian longitudinal (21) du moyen d'aspiration (11) est disposé parallèlement aux axes de rotation (20) des moyens de transport (3, 3a).

10. Procédé pour le mouillage d'une surface de substrat (4) d'un substrat (2) fabriqué notamment à partir d'une matière première en silicium avec une substance de traitement (10) comportant les parties suivantes :
- Transport du substrat (2) par des moyens de transport (3, 3a) dans un plan de transport (5),
- Mouillage d'une surface de substrat (4) située au moins essentiellement dans le plan de transport (5) et orientée vers le bas par une substance de traitement (10), qui est appliquée par un moyen d'acheminement (3a) à la surface de substrat (4),
- L'aspiration de la substance de traitement (10) volatilisée et/ou nébulisée par des moyens d'aspiration (11) disposés en direction verticale au-dessous du plan de transport (5), pour éviter une retombée de la substance de traitement (10) sur une surface de substrat différente de celle (4) qui est disposée dans le plan de transport (5).

11. Procédé d'après la revendication 10, **caractérisé par** un transport continu de substrat (2) et/ou un approvisionnement continu en substance de traitement (10) par le moyen d'acheminement pour le mouillage de la surface de substrat (4) et/ou une aspiration continue de substance de traitement (10) gazeuse et/ou nébuleuse.
